# EUROPEAN PATENT SPECIFICATION

(11) **EP 4 457 378 B1**
(45) Date of publication and mention of the grant of the patent: **09.09.2026**
(21) Application number: 22859484.2
(22) Date of filing: 27.12.2022
(51) Int. Cl.: C07F 7/22, G03F 7/00, C23C 16/40, C23C 16/455, C23C 16/56, G03F 7/16, H10P 14/60, H10P 14/692, H10P 76/40

(54) **AZASTANNATRANES, STANNATRANES, AND METHODS OF PREPARATION AND USE THEREOF**
AZASTANNATRANE, STANNATRANE UND VERFAHREN ZUR HERSTELLUNG UND VERWENDUNG DAVON
AZASTANNATRANES, STANNATRANES ET LEURS PROCÉDÉS DE PRÉPARATION ET D'UTILISATION

(30) Priority: 28.12.2021 US 202163294089 P
(43) Date of publication of application: 06.11.2024
(73) Proprietor: Gelest, Inc., Morrisville, PA 19067 (US)
(72) Inventor: PAN, Youlin, Langhorne, PA 19407 (US); ARKLES, Barry, C., Pipersville, PA 18947 (US); LIBERATORE, Richard, J., Philadelphia, PA 19134 (US)
(74) Representative: Vossius & Partner Patentanwälte Rechtsanwälte mbB
(86) International application number: PCT/US2022/054045
(87) International publication number: WO 2023/129529

(56) References cited:
- KR-A- 20200 057 288
- US-A- 5 344 948

## Description

### CROSS-REFERENCE TO RELATED APPLICATIONS

This application claims priority to U.S. provisional patent application number 63/294,089, filed December 28, 2021.

### BACKGROUND OF THE INVENTION

As semiconductor fabrication continues to advance, feature sizes continue to shrink, driving the need for new processing methods. Certain organotin compounds have been shown to be useful in the deposition of tin oxide hydroxide coatings in applications such as extreme ultraviolet (EUV) lithography techniques. For example, alkyl tin compounds provide radiation sensitive Sn-C bonds that can be used to pattern structures lithographically.

Materials used in microelectronic fabrication are required to be extremely pure with tight limits placed on organic contamination (e.g., reaction by-products), metallic contamination, and particulate contamination. Purity requirements are stringent in general, and particularly for lithography applications because the chemical is in contact with the semiconductor substrates and the organometallic impurities in compounds such as isopropyltris(dimethylamino)stannane ((iPr)Sn(NMe₂)₃), which contain the dialkyl tin byproduct diisopropylbis(dimethylamino)stannane, can affect the properties of the resultant film. Exact targets for purities are determined by a variety of factors, including performance metrics, but typical minimum purity targets are greater than 99.9%. Residual metals present in the chemicals can be deposited onto the semiconductor substrate and degrade the electrical performance of the device being fabricated. Typical specification for metals are less than 10 ppb for individual metals and total metal not to exceed ~100 ppb.

The processing and performance of semiconductor material can also be sensitive to dialkyl tin contaminants. Dialkyl tin impurities R₂SnX₂, for example R₂SnCl₂, R₂Sn(NMe₂)₂, etc., are often the source of off-gassing after vapor phase deposition or spin-on coating processes due to the oxostannate cluster films being less dense when the film contains dialkyl groups. Dialkyl tin compounds are frequently minor components in monoalkyl tin compounds as byproducts of synthesis, redistribution during storage or formation during deposition. To produce microelectronic products using EUV lithography, the proper control of dialkyl tin contaminants is required. The high purity required from the mono-alkyl tin precursor manufacturing process becomes a challenge. Azastannatranes and stannatranes are attractive because their chemical structures resist redistribution reactions that result in formation of dialkyl tin derivatives and enable deposition of high purity tin-containing films.
US 5 344 948 A concerns a specific method for applying a film to the surface of a substrate by employing the techniques of chemical vapor deposition, incluiding the thermal decomposition of vapors comprising single-source molecular organic chemical vapor deposition agents or precursors.
KR 2020 0057288 A mentions an etching solution composition comprising a specfic type of silane compound having a chemical shift value of -120 to -60 ppm in the ²⁹Si-NMR of tetramethylsilane based on a value of 0 ppm in the ²⁹Si-NMR of tetramethylsilane by liquid nuclear magnetic resonance.

### BRIEF SUMMARY OF THE INVENTION

In one embodiment, aspects of the disclosure relate to a stannatrane having formula (I): 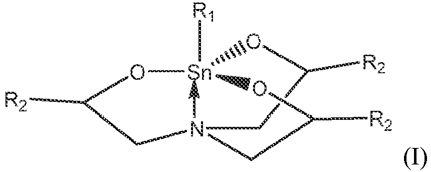 wherein R₁ is a substituted or unsubstituted, linear or branched, alkyl group having one to about ten carbon atoms, a substituted or unsubstituted cycloalkyl group having three to about twenty carbon atoms, or a substituted or unsubstituted alkenyl group having two to about ten carbon atoms, and each R₂ is independently hydrogen or a substituted or unsubstituted, linear or branched, alkyl group having one to about ten carbon atoms, provided that at least one R₂ is not hydrogen. The optional substituent is as defined in claim 1.

In a second embodiment, aspects of the disclosure relate to an azastannatrane having formula (II): 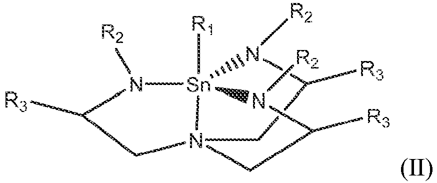 wherein R₁ is a substituted or unsubstituted, linear or branched, alkyl group having one to about ten carbon atoms, a substituted or unsubstituted cycloalkyl group having three to about twenty carbon atoms, or a substituted or unsubstituted alkenyl group having two to about ten carbon atoms, each R₂ is independently hydrogen or a substituted or unsubstituted, linear or branched, alkyl group having one to about ten carbon atoms, and each R₃ is independently hydrogen or a substituted or unsubstituted, linear or branched, alkyl group having one to about ten carbon atoms, provided that at least one R₃ is not hydrogen. The optional substituent is as defined in claim 9.

In summary, the following embodiments are proposed as particularly preferred in the scope of the present invention:
Embodiment 1: A stannatrane having formula (I): 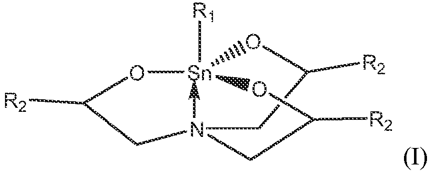 wherein R₁ is a substituted or unsubstituted, linear or branched, alkyl group having one to about ten carbon atoms, a substituted or unsubstituted cycloalkyl group having three to about twenty carbon atoms, or a substituted or unsubstituted alkenyl group having two to about ten carbon atoms, and each R₂ is independently hydrogen or a substituted or unsubstituted, linear or branched, alkyl group having one to about ten carbon atoms, provided that at least one R₂ is not hydrogen, wherein the optional substituent is as defined in claim 1.
Embodiment 2: The stannatrane according to embodiment 1, having the formula 1-n-butyl-3,7,10-trimethyl-2,8,9-trioxa-5-aza-1-stannabicyclo[3.3.3] undecane: 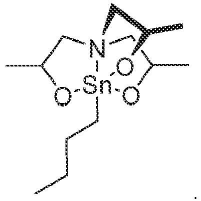
Embodiment 3: The stannatrane according to embodiment 1, having the formula 1-(3,3,3-trifluoropropyl)-3,7,10-trimethyl-2,8,9-trioxa-5-aza-1-stannabicyclo[3.3.3] undecane: 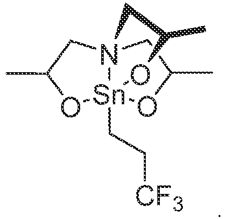
Embodiment 4: The stannatrane according to embodiment 1, having the formula 1-iso-propyl-3,7,10-trimethyl-2,8,9-trioxa-5-aza-1-stannabicyclo[3.3.3] undecane: 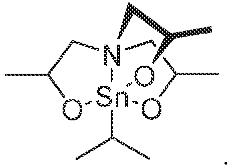
Embodiment 5: The stannatrane according to any of embodiments 1-4, having a purity of at least about 99.9%.
Embodiment 6: The stannatrane according to any of embodiments 1-5, wherein the stannatrane contains less than about 0.1 % dialkyl tin compounds.
Embodiment 7: A method for forming a stannatrane according to any of embodiments 1-6, the method comprising:
   reacting an alkali metal alkoxide with a triisopropanolamine and an alkyltin trichloride compound having formula R₁SnCl₃.
Embodiment 8: A method for forming a stannatrane according to any of embodiments 1-6, the method comprising:
   reacting an alkyltris(dimethylamino)tin compound having formula R₁Sn(NMe₂)₃ with triisopropanolamine.
Embodiment 9: An azastannatrane having formula (II): 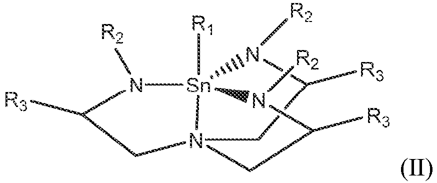 wherein R₁ is a substituted or unsubstituted, linear or branched, alkyl group having one to about ten carbon atoms, a substituted or unsubstituted cycloalkyl group having three to about twenty carbon atoms, or a substituted or unsubstituted alkenyl group having two to about ten carbon atoms, each R₂ is independently hydrogen or a substituted or unsubstituted, linear or branched, alkyl group having one to about ten carbon atoms, and each R₃ is independently hydrogen or a substituted or unsubstituted, linear or branched, alkyl group having one to about ten carbon atoms, provided that at least one R₃ is not hydrogen, wherein the optional substituent is as defined in claim 9.
Embodiment 10: The azastannatrane according to embodiment 9, having a purity of at least about 99.9%.
Embodiment 11: The azastannatrane according to embodiment 9 or 10, wherein the azastannatrane contains less than about 0.1 % dialkyl tin compounds.
Embodiment 12: A method for forming an azastannatrane according to any of embodiments 9-11, the method comprising:
   reacting an alkyltris(dimethylamino)tin compound having formula R₁Sn(NMe₂)₃ with tris(2-aminoethyl)amine.
Embodiment 13: A method for forming an oxostannate film comprising:
   providing a substrate;
   coating the substrate with a solution of a stannatrane according to any of embodiments 1-6;
   drying and/or heating the coated substrate;
   irradiating the coated substrate; and
   exposing the irradiated substrate to oxygen or moisture to form the oxostannate film on the substrate.
Embodiment 14: A method for forming an oxostannate film comprising:
   providing a substrate;
   coating the substrate with a solution of an azastannatrane according to any of embodiments 9-11;
   drying and/or heating the coated substrate;
   irradiating the coated substrate; and
   exposing the irradiated substrate to oxygen or moisture to form the oxostannate film on the substrate.
Embodiment 15: A method for forming an oxostannate film comprising:
   vaporizing or providing an aerosol of the stannatrane according to any of embodiments 1-6;
   providing a substrate;
   physisorbing or chemisorbing the vaporized or aerosolized stannatrane onto the substrate; and
   exposing the physisorbed or chemisorbed stannatrane to a sequence of hydrolysis and irradiation steps followed by an oxidation or second hydrolytic exposure to form the oxostannate film on the substrate.
Embodiment 16: A method for forming an oxostannate film comprising:
   vaporizing or providing an aerosol of an azastannatrane according to any of embodiments 9-11;
   providing a substrate;
   physisorbing or chemisorbing the vaporized or aerosolized azastannatrane onto the substrate; and
   exposing the physisorbed or chemisorbed azastannatrane to a sequence of hydrolysis and irradiation steps followed by an oxidation or second hydrolytic exposure to form the oxostannate film on the substrate.
Embodiment 17: A method for forming a patterned film comprising preparing the oxostannate film according to embodiment 13 and exposing the film to non-continuous radiation by rastering with an electron beam or laser or lithographic masking.
Embodiment 18: A method for forming a patterned film comprising preparing the oxostannate film according to embodiment 14 and exposing the film to non-continuous radiation by rastering with an electron beam or laser or lithographic masking.
Embodiment 19: A method for forming a patterned film comprising preparing the oxostannate film according to embodiment 15 and exposing the film to non-continuous radiation by rastering with an electron beam or laser or lithographic masking.
Embodiment 20: A method for forming a patterned film comprising preparing the oxostannate film according to embodiment 16 and exposing the film to non-continuous radiation by rastering with an electron beam or laser or lithographic masking.
Embodiment 21: A method for forming a continuous film comprising preparing the oxostannate film according to embodiment 13 and exposing the film to blanket exposure utilizing a suitable lithographic mask to provide optically clear tin oxide conductive film.
Embodiment 22: A method for forming a continuous film comprising preparing the oxostannate film according to embodiment 14 and exposing the film to blanket exposure utilizing a suitable lithographic mask to provide optically clear tin oxide conductive film.
Embodiment 23: A method for forming a continuous film comprising preparing the oxostannate film according to embodiment 15 and exposing the film to blanket exposure utilizing a suitable lithographic mask to provide optically clear tin oxide conductive film.
Embodiment 24: A method for forming a continuous film comprising preparing the oxostannate film according to embodiment 16 and exposing the film to blanket exposure utilizing a suitable lithographic mask to provide optically clear tin oxide conductive film.

### BRIEF DESCRIPTION OF THE SEVERAL VIEWS OF THE DRAWINGS

The following detailed description of preferred embodiments of the present invention will be better understood when read in conjunction with the appended drawing. For the purposes of illustrating the invention, there are shown in the drawings embodiments which are presently preferred. It is understood, however, that the invention is not limited to the precise arrangements and instrumentalities shown. In the drawings:
Fig. 1a is an XPS spectrum of silicon wafers coated with 1-n-butyl-3,7,10-trimethyl-2,8,9-trioxa-5-aza-1-stannabicyclo[3.3.3] undecane according to one embodiment of the disclosure;
Fig. 1b is an XPS spectrum of silicon wafers coated with 1-n-butyl-3,7,10-trimethyl-2,8,9-trioxa-5-aza-1-stannabicyclo[3.3.3] undecane according to another embodiment of the disclosure;
Fig. 2a is an XPS spectrum of silicon wafers coated with 1-iso-propyl-3,7,10-trimethyl-2,8,9-trioxa-5-aza-1-stannabicyclo[3.3.3] undecane according to one embodiment of the disclosure;
Fig. 2b is an XPS spectrum of silicon wafers coated with 1-iso-propyl-3,7,10-trimethyl-2,8,9-trioxa-5-aza-1-stannabicyclo[3.3.3] undecane according to another embodiment of the disclosure;
Fig. 3a is an XPS spectrum of silicon wafers coated with 1-(3,3,3-trifluoropropyl)-3,7,10-trimethyl-2,8,9-trioxa-5-aza-1-stannabicyclo[3.3.3] undecane according to one embodiment of the disclosure; and
Fig. 3b is an XPS spectrum of silicon wafers coated with 1-(3,3,3-trifluoropropyl)-3,7,10-trimethyl-2,8,9-trioxa-5-aza-1-stannabicyclo[3.3.3] undecane according to another embodiment of the disclosure.

### DETAILED DESCRIPTION OF THE INVENTION

Aspects of the disclosure relate to methods for the preparation of soluble, high purity, cyclic tin compounds which may be used to prepare high density tin oxide nanostructured materials by first forming organotin films, followed by conversion to inorganic thin films by drying with optional heating and/or exposure to UV light, EUV light, or electron-beam radiation. The resulting films have a high optical density and reduced volatile byproducts associated with dialkyl tin species which are intrinsic in other tin precursors or are formed as byproducts during the deposition process. The volatile byproducts of concern which are eliminated herein are species that volatize during processing but adsorb onto the surfaces of chambers, exposure, and process related equipment, causing downtime and or loss of definition of the features. The genesis of these impurities are associated with Kocheshkov rearrangement of alkyl tin compounds.

More specifically, the disclosure relates to two classes of cyclic tin compounds, trioxa-aza-1-stannabicyclo-[3.3.3]-undecanes, more conveniently referred to as stannatranes, and tetraaza-1-stannabicyclo-[3.3.3] undecanes, more conveniently referred to as azastannatranes. These cyclic tin compounds are resistant to Kocheshkov rearrangement and the generation of dialkyl tin impurities is not observed during the synthesis, purification or deposition of these compounds to form oxostannate films. These cyclic tin compounds are stable at room temperature but are capable of reacting as a vapor or aerosol with a solid substrate or being deposited from a solution onto a substrate. Upon subsequent exposure to UV irradiation (in particular to extreme UV radiation), these compounds lose their organic substituents to form oxostannate films that resists shrinkage. The films may be patterned by controlled exposure by rastering with an electron beam or laser or converted in blanket conversion utilizing a suitable lithographic mask to provide optically clear tin oxide conductive films. In the structural formulas depicted throughout this disclosure, the bond between the tertiary nitrogen is usually considered coordinative, though it may be depicted as either coordinative or covalent.

### Stannatranes and Azastannatranes

Stannatranes according to aspects of the disclosure have general formula (I):

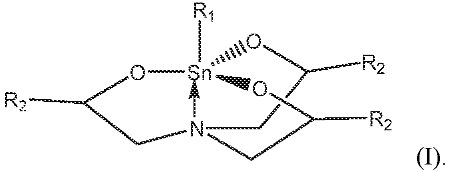

In formula (I), R₁ is a substituted or unsubstituted, linear or branched, alkyl group having one to about ten carbon atoms, a substituted or unsubstituted cycloalkyl group having three to about twenty carbon atoms, or a substituted or unsubstituted alkenyl group having two to about ten carbon atoms; preferred R₁ groups include methyl, ethyl, n-propyl, isopropyl, and n-butyl. Each R₂ is independently hydrogen or a substituted or unsubstituted, linear or branched alkyl group having one to about ten carbon atoms, provided that at least one R₂ is not hydrogen. Preferably, each R₂ is an alkyl group, most preferably a methyl group. If R₁ and/or R₂ are substituted, they are substituted with one or more halogen atoms (such as chloro, bromo, fluoro, or iodo, including partial or full halogenation), or a trimethylsilyl group.

Exemplary stannatranes include 1-n-butyl-3,7,10-trimethyl-2,8,9-trioxa-5-aza-1-stannabicyclo[3.3.3] undecane, 1-(3,3,3-trifluoropropyl)- 3,7,10-trimethyl-2,8,9-trioxa-5-aza-1-stannabicyclo[3.3.3] undecane, and 1-iso-propyl-3,7,10-trimethyl-2,8,9-trioxa-5-aza-1-stannabicyclo[3.3.3] undecane, shown below:

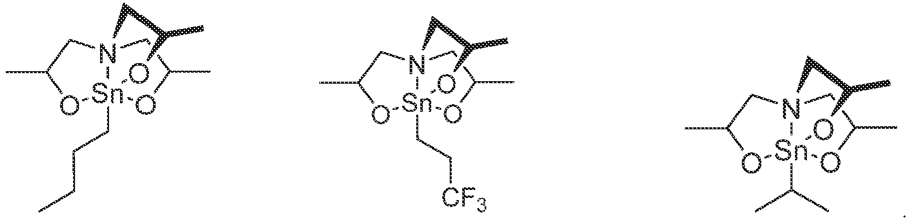

Azastannatranes according to aspects of the disclosure have general formula (II):

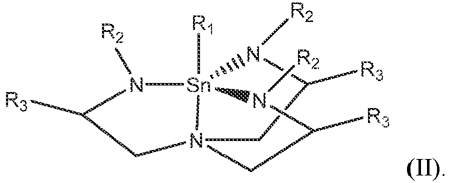

In formula (II), R₁ is a substituted or unsubstituted, linear or branched, alkyl group having one to about ten carbon atoms, a substituted or unsubstituted cycloalkyl group having three to about twenty carbon atoms, or a substituted or unsubstituted alkenyl group having two to about ten carbon atoms; preferred R₁ groups include methyl, ethyl, n-propyl, isopropyl, and n-butyl. Each R₂ is independently hydrogen or a substituted or unsubstituted, linear or branched alkyl group having one to about ten carbon atoms. Each R₃ is independently hydrogen or a substituted or unsubstituted, linear or branched alkyl group having one to about ten carbon atoms, provided that at least one R₃ is not hydrogen. Preferably, each R₂ and R₃ is an alkyl group, most preferably a methyl group. If R₁ and/or R₂ and/or R₃ are substituted, they are substituted with one or more halogen atoms (such as chloro, bromo, fluoro, or iodo, including partial or full halogenation), or a trimethylsilyl group.

An exemplary azastannatrane is 1-iso-propyl-2,5,8,9-tetraaza-1-stannabicyclo[3.3.3] undecane, shown below:

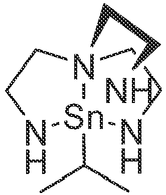

In preferred compounds having formulas (I) and (II), the CH₂CH₂ group bridging oxygen and nitrogen atoms is substituted, that is, R₂ in formula (I) and R₃ in formula (II) is an alkyl group, preferably methyl. These compounds are preferred since they have lower melting points and greater solubility than their unsubstituted analogs. In order to be effective in EUV or other deposition processes, most preferred R₁ substituents are alkyl groups with two or more carbons, such as ethyl, isopropyl, or n-butyl.

The stannatranes and azastannatranes according to aspects of the disclosure exhibit thermal stability and storage stability either neat or in solution. Specifically, no decomposition has been observed for solutions of the compounds described herein after eight hours of UV light exposure or one week of heating at 35°C. Further, when the stannatranes or azastannatranes are synthesized as mixtures of cis and trans isomers (which may be separated and characterized), such isomeric mixtures are also stable.

The stannatranes and azastannatranes described herein have high purity, such as greater than 98%, greater than 99%, greater than 99.5%, greater than 99.7%, greater than 99.8%, greater than 99.9%, or even higher, as measured by known analytical methods such as ¹¹⁹Sn NMR. Specifically, the stannatranes and azastannatranes contain low levels (such as less than 2%, less than 1%, less than 0.5%, less than 0.3%, less than 0.2%, less than 0.1%, or lower) of dialkyl tin impurities such as, among others, dialkylbis(dimethylamino)stannane. For the purposes of purity analysis, the diastereomers of the compounds described herein may be considered to be the same compound.

### Methods

According to aspects of the disclosure, methods of making a stannatrane having formula (I) involve alkoxylation of an alkyl tin halide. Specifically, one method according to the disclosure involves reacting an alkali metal alkoxide with a triisopropanolamine and an alkyltin trichloride having formula R₁SnCl₃. The appropriate reaction conditions may be determined by routine experimentation, including the specific solvent, which may be protic or aprotic. In preferred embodiments, the method involves combining the triisopropanolamine (preferably in a solvent, such as methanol) with an excess of alkali metal alkoxide, such as sodium methoxide, preferably in a solvent such as methanol or triethylamine. Subsequently, the alkyltin trichloride (or other alkyl tin halide) is added to the reaction mixtures in a solvent (such as in toluene), such that the alkyltin trichloride is added in a 1:1 molar ratio relative to the triisopropanolamine. The reaction temperature is controlled, such as to below about 60°C, preferably about 20°C to about 60°C. After completion of the reaction (which may be monitored by ¹¹⁹Sn NMR), the product is purified by known methods, such as fractional distillation.

A second method involves reacting an alkyltris(dimethylamino)tin compound having formula R₁Sn(NMe₂)₃ with triisopropanolamine. The appropriate reaction conditions may be determined by routine experimentation, including the specific solvent, which is preferably a protic solvent such as hexanes or toluene, or an aprotic solvent such as THF. In preferred embodiments, the method involves combining the alkyltris(dimethylamino)tin compound with the triisopropanolamine (preferably in a solvent, such as toluene) such that the alkyltris(dimethylamino)tin compound and the triisopropanolamine are combined in a 1:1 molar ratio. The reaction temperature is controlled, such as to below about 60°C, preferably about 20°C to about 60°C. After completion of the reaction (which may be monitored by ¹¹⁹Sn NMR), the product is purified by known methods, such as fractional distillation.

According to another aspect of the disclosure, a method of making an azastannatrane having formula (II) involves transamination of an organostannylamine. Specifically, azastannatranes having formula (II) may be prepared by reacting an alkyltris(dimethylamino)tin compound having formula R₁Sn(NMe₂)₃ with tris(2-aminoethyl)amine. The appropriate reaction conditions may be determined by routine experimentation, including the specific solvent, which is preferably a protic solvent such as hexanes or toluene, or an aprotic solvent such as THF. In preferred embodiments, the method involves combining the alkyltris(dimethylamino)tin compound with the tris(2-aminoethyl)amine (preferably in a solvent, such as toluene) such that the alkyltris(dimethylamino)tin compound and the tris(2-aminoethyl)amine are combined in a 1:1 molar ratio. The reaction temperature is controlled, such as to below about 60°C, preferably about 20°C to about 60°C. After completion of the reaction (which may be monitored by ¹¹⁹Sn NMR), the product is purified by known methods, such as fractional distillation.

### Films

Oxostannate films prepared from the stannatrane and azastannatrane compounds described herein are resistant to shrinkage during conversion to patterned structures or reduced stress-cracking for continuous films. They also can form films with greater than 80% optical transmission in the visual wavelength region with sufficient electrical conductivity to form electrodes.

The oxostannate films described herein may alternately be described as SnO:H films. The films may be patterned by controlled exposure by rastering with an electron beam or laser or converted in blanket conversion utilizing a suitable lithographic mask to provide optically clear fluorine doped tin oxide conductive films.

A method for forming an oxostannate film according to aspects of the disclosure comprises: vaporizing or providing an aerosol of a stannatrane compound having formula (I) or an azastannatrane compound having formula (II); providing a substrate; physisorbing or chemisorbing the vaporized or aerosolized stannatrane or azastannatrane onto the substrate; and exposing the physisorbed or chemisorbed stannatrane or azastannatrane to a sequence of hydrolysis and irradiation steps followed by an oxidation or second hydrolytic exposure to form the oxostannate film on the substrate. The resulting film has high purity and no dialkyl tin compound contamination. Each of these steps will be described in more detail below.

In the first method step, the stannatrane or azastannatrane is vaporized or aerosolized by entrainment in a carrier gas such as nitrogen or argon or by volatization in a vacuum at an appropriate temperature and then transported to the substrate. Any type of substrate known in the art on which it would be desirable to form a film would be appropriate such as, without limitation, a substrate containing one or more metal layers, dielectric materials, semiconductor materials, or combinations thereof, including oxides, nitrides, and polysilicon materials, for example.

Subsequently, the vaporized or aerosolized precursor is physisorbed or chemisorbed onto the substrate using standard techniques associated with CVD, ALD, or similar deposition processes.

Next, the physisorbed or chemisorbed tin compound is pulsed with water (preferably as a vapor) to remove the hydrolytically unstable substituents and replace them with hydroxyl groups (hydrolysis), forming an organostannasesquioxane (organotin oxide hydroxide) coating. In a subsequent step (irradiation), the adsorbed coating is exposed to radiation (preferably EUV) at a wavelength that ruptures the Sn-C bond. Maximum energy levels of irradiation of ~50mJ/cm² and more preferably below 10mJ/cm² are utilized to avoid damage to the substrate. Ultimately, all of the Sn-C bonds are replaced with Sn-O bonds, which are formed concomitant with or subsequent to irradiation by exposure to oxygen or water in ambient air.

In particular, strong absorption of extreme ultraviolet light associated with tin is observed at 13.5 nm. Most organic moieties bonded to tin have strong absorption of ultraviolet light at 193 nm wavelength and relatively strong absorption up to 230nm. Accordingly, appropriate wavelengths for the irradiation range from 13.5 to 280 nm, which include EUV and deep UV. At sufficient energy absorption at these wavelengths, the metal-organic bond is cleaved. Simultaneously with or after the cleavage reaction, additional oxo-bridges between the tin atoms are formed either by oxidative, hydrolytic or hydroxyl displacement reactions.

A second method for forming an oxostannate film according to aspects of the disclosure comprises: providing a substrate, coating the substrate with a solution of a stannatrane having formula (I) or an azastannatrane having formula (II), drying and/or heating the coated substrate, irradiating the coated substrate, and exposing the irradiated film to oxidation or water/moisture in ambient air to form the oxostannate film on the substrate. The resulting film has high purity and no dialkyl tin compound contamination.

Appropriate substrates have been described previously. The solution of stannatrane or azastannatrane may be prepared in any solvent known in the art or to be developed such as, for example, an alcohol such as the currently preferred ethanol, or an aprotic solvent, such as THF. The concentration of the stannatrane or azastannatrane in the solvent may be determined by routine experimentation, but may be, for example, about 50 to 20 %, preferably about 10 to 15% by weight. Any known method for applying a solution to a substrate may be employed, such as, for example, dip coating or spin-on methods.

The coated substrate is dried either at room temperature for a sufficient time to be determined by routine experimentation, such as overnight, or with heating (annealing), such as to about 100°C to 150°C, preferably about 120°C to 125°C, to effect thermal conversion. Finally, the coated substrate is irradiated as previously described and then exposed to oxygen or moisture in ambient air to form the oxostannate film.

While not wishing to be bound by theory, the presently claimed method steps, as well as condensation processes of tin-hydroxyl groups to form stannoxane bonds, are believed to result in denser films which at some levels are desirable but may also result in shrinkage and distortion which affects the fidelity of the lithographic processes or induces stress-cracking in continuous films. Accordingly, the films prepared by the methods described herein achieve the objective of reducing shrinkage of films after radiation exposure. However, other critical performance requirements must be satisfied, including sufficient optical cross-section, film formation on substrate, dose sensitivity (photosensitivity), storage stability (thermal stability), volatile components (off-gassing during exposure or inherent in the compound.) Each of these requirements is described in more detail below.

### High optical cross section

A tin-oxo cluster/polymer material has proven to be a promising EUV resist. Notably, the hydroxy-terminated SnOx underlayer on the surface of the substrate material can enhance the absorption of radiation upon the irradiating of the imaging layer and generate secondary electrons from the substrate to further harvest additional EUV photons, making the EUV patterning process more sensitive and reducing the required EUV dose necessary for imaging layer exposure. Among elements of the Periodic Table, tin has a notably high optical cross-section.

### Film formation - Substrate Reactivity.

A metal-organic (RMX₃) compound must contain a hydrolyzable ligand-metal bond, where X is the ligand with a hydrolysable M-X bond. In the compounds described herein, R is an alkyl group (R₁) and X represents the three-nitrogen bridge or the three-oxygen bridge. In particular, an appropriate organotin compound must be able form a film/polymer/clusters on a wafer surface by CVD, ALD, or spin on. If the application or deposition is in the condensed phase spin-on, the clusters can be formed in a liquid precursor prior to deposition but this typically causes greater shrinkage.

### Dose sensitivity (photosensitivity)

It is believed that the R group of the cyclic tin compound plays a key role as UV sensitivity for EUV resist material since films imaging layer of a SnOx thin film that contains or is terminated with alkyl groups is selected such that they will undergo tin-carbon bond cleavage, such as beta-hydride elimination upon irradiation with EUV light. In an EUV patterning step, the alkyl groups can be cleaved, leaving regions of Sn-H bonds while the unexposed surfaces remain alkyl-terminated. The films after exposure to EUV undergo changes, not limited to the loss of organic pendant substituents bonded to metal atoms in low density M-OH rich materials, allowing their crosslinking to denser M-O-M bonded metal oxide materials. The Sn-H bonds, which can be described as tin hydrides, are oxidatively and hydrolytically sensitive and form oxides. The hydrolytic reaction of tin hydrides generates hydrogen, which although a volatile byproduct does not behave as a contaminant.

### Storage Stability

Tin compounds have a strong tendency to undergo disproportionation reactions, also referred to as the Kocheshkov comproportionation reaction. This reaction is accelerated with increased temperature. Storage stability at temperatures compatible with semiconductor production lines, approximately 20-35°C is highly desirable. Implicit in the performance of the materials is the requirement for moisture reactivity which means moisture sensitivity. Accordingly, the storage stability must be considered while supplying the material and long-term storage as a manufacture.

### Volatile components

While the tin compound must have sufficient volatility to be transported to the substrate by vapor deposition methods, components that are volatile and not reactive with the substrate must be minimized since they will diffuse to non-targeted areas. The typical sources of these volatile components result from comproportionation during manufacture or storage and non-comproportionation byproducts formed during radiation exposure.

The disclosure also relates to a method for forming a patterned film which involves preparing the oxostannate film described herein and exposing the film to non-continuous radiation by means of rastering with an electron beam or laser or lithographic masking.

The disclosure also relates to a method for forming a continuous film comprising preparing the oxostannate film described herein and exposing the film to blanket exposure utilizing a suitable lithographic mask to provide optically clear oxostannate conductive films.

The invention will now be described in connection with the following, non-limiting examples.

### Example 1: Synthesis of 1-n-Butyl- 3,7,10-trimethyl-2,8,9-trioxa-5-aza-1-stannabicyclo[3.3.3] undecane

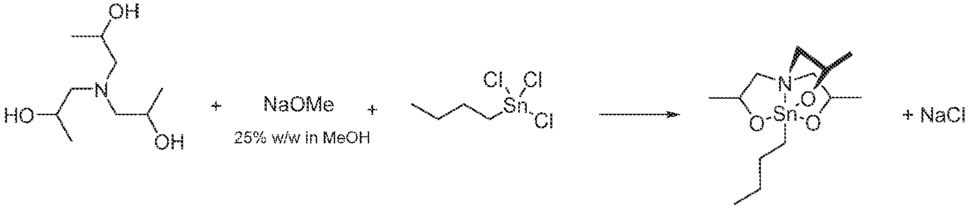

Under an inert atmosphere, a 2 L four-neck round bottom flask equipped with a mechanical stirrer, pot thermometer, thermowell, and addition funnel was charged with 124 g (0.65 mol) triisopropanolamine and 235 mL methanol. To the flask was added 421 g (1.95 mol) of a 25% w/w solution of sodium methoxide in methanol. Next, a solution of 183 g n-BuSnCl₃ (0.65 mol) in 550 mL toluene was added dropwise to the flask over 1 h while maintaining the pot temperature below 40 °C. Reaction progress was monitored by ¹¹⁹Sn NMR. After the reaction was completed, the reaction was stripped to a pot temperature of 120 °C and the resulting concentrate was filtered in an air-free filter. The product was purified at reduced pressure by fractional distillation through a Vigreux column (isolated at 136-9 °C at 0.5 torr (0.067 kPa)) to give 147 g (61%) of a thick, pale-yellow oil. The product was confirmed by ¹H and ¹¹⁹Sn NMR spectroscopy as a pair of diastereomers with a ratio of ca. 3:1, having the properties shown in Table 1. By ¹¹⁹Sn NMR less than 0.1% concentration of any dialkyl tin species was observed.

UV Exposure: The product was exposed to 8 hours of illumination and no traces of decomposition were observed in either ¹¹⁹Sn or ¹H NMR spectra. No signs of decomposition of the product sample were observed. By ¹¹⁹Sn NMR less than 0.1% concentration of any dialkyl tin species was observed.

Heat Exposure: The product was exposed to heat at 35 °C for one week and no traces of decomposition were observed in either ¹¹⁹Sn or ¹H NMR spectra. No signs of decomposition of the product sample were observed. By ¹¹⁹Sn NMR less than 0.1% concentration of any dialkyl tin species was observed.

**Table 1: Properties of 1-n-butyl-3,7, 10-trimethyl-2,8,9-trioxa-5-aza-1-stannabicyclo[3.3.3] undecane**

| **Structure** | **¹¹⁹Sn Peak (ppm,CDCl3)** | **¹H Peaks (ppm, CDCl₃)** | **Physical Properties** |
|---|---|---|---|
| 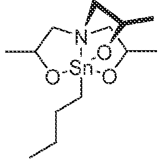 | -188 (minor diastereomer) | Peak constitutes both diastereomers unless noted | Very viscous eutectic liquid. |
| | -192 (major diastereomer) | | |
| | | | BP = 130 °C/0.4 mmHg |
| | | 4.109 (m, 1H, major) | |
| | | 3.865 (m, 2H, major, and 3H, minor) | Solidifies over time. |
| | | 3.035 (dd, 1H, major) | |
| | | 3.002 (dd, 1H, major) | |
| | | 2.853 (dd, 1H, major) | |
| | | 2.779 (dd, 3H, minor) | |
| | | 2.637 (dd, 1H, major)) | |
| | | 2.34 (t, 3H, minor) | |
| | | 2.30 (t, 1H, major) | |
| | | 2.27 (t, 1H, major) | |
| | | 1.69 (m, 2H) | |
| | | 1.37 (m, 4H) | |
| | | 1.20 (m, 9H) | |
| | | 0.88 (m, 3H) | |

### Example 2: Synthesis of 1-(3,3,3-Trifluoropropyl)- 3,7,10-trimethyl-2,8,9-trioxa-5-aza-1-stannabicyclo[3.3.3] undecane

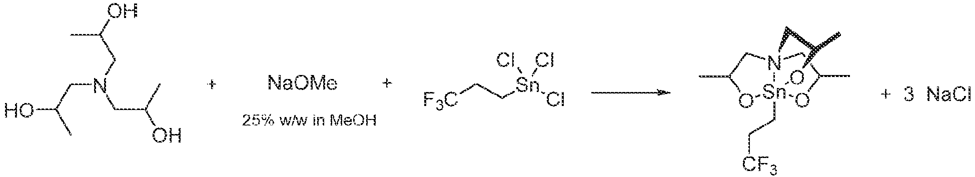

Under an inert atmosphere, a 500 mL three-neck round bottom flask equipped with a magnetic stirrer, pot thermometer, thermowell, and addition funnel was charged with 38.25g (0.20 mol) triisopropanolamine and 73 mL methanol. To the flask was added 130 g (0.60 mol) of a 25% w/w solution of sodium methoxide in methanol. Next, a solution of 64.42 g (0.20 mol) CF₃CH₂CH₂SnCl₃ in 162 mL toluene was added dropwise to the flask over 1 h while maintaining the pot temperature below 40 °C. The reaction progress was monitored by ¹¹⁹Sn NMR. After the reaction was completed, the reaction was stripped to a pot temperature of 120 °C and the resulting concentrate was filtered in an air-free filter. The product was purified by distillation at reduced pressure (isolated at 126-128 °C at 0.3 torr (0.04 kPa)) to give 56.6g (70%) of a crystalline, pale-yellow solid. The product was confirmed by ¹H and ¹¹⁹Sn NMR spectroscopy as a pair of diastereomers with a ratio of ca. 3:1, having the properties shown in Table 2. By ¹¹⁹Sn NMR less than 0.1% concentration of any dialkyl tin species was observed.

UV Exposure: The product in a saturated cyclohexane solution was exposed to 8 hours of illumination and no traces of decomposition were observed in either ¹¹⁹Sn or ¹H NMR spectra. No signs of decomposition of the product sample were observed. By ¹¹⁹Sn NMR less than 0.1% concentration of any dialkyl tin species was observed.

Heat Exposure: The product in a saturated cyclohexane solution was exposed to heat at 35 °C for one week and no traces of decomposition were observed in either ¹¹⁹Sn or ¹H NMR spectra. No signs of decomposition of the product sample were observed. By ¹¹⁹Sn NMR less than 0.1% concentration of any dialkyl tin species was observed.

**Table 2: Properties of 1-(3,3,3-Trifluoropropyl)- 3,7, 10-trimethyl-2,8,9-trioxa-5-aza-1-stannabicyclo[3.3.3]undecane**

| **Structure** | **¹¹⁹Sn Peak (ppm, CDCl₃)** | **¹H Peaks (ppm, CDCl₃)** | **Physical Properties** |
|---|---|---|---|
| 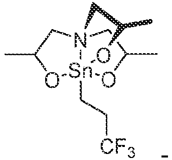 | -186 (major diastereomer) | Peak constitutes both diastereomers unless noted | White to yellow, crystalline solid |
| | -188 (minor diastereomer) | | MP = 70-1 °C (DSC). |
| | | 4.10 (m, 1H, major) | |
| | | 3.85 (m, 2H, major, and 3H minor) | BP = 126 °C/0.65 mm Hg |
| | | 3.10 (dd, 1H, major) | |
| | | 3.02 (dd, 1H, major) | |
| | | 2.90 (dd, 1H, major) | |
| | | 2.82 (dd, 3H, minor) | |
| | | 2.65 (dd, 1H, major) | |
| | | 2.49 (m, 2H) | |
| | | 2.35 (t, 3H, minor) | |
| | | 2.30 (t, 1H, major) | |
| | | 2.27 (t, 1H, major) | |
| | | 1.43 (m, 2H) | |
| | | 1.20 (m, 9H) | |

### Example 3: Synthesis of 1-iso-propyl-3,7,10-trimethyl-2,8,9-trioxa-5-aza-1-stannabicyclo[3.3.3] undecane

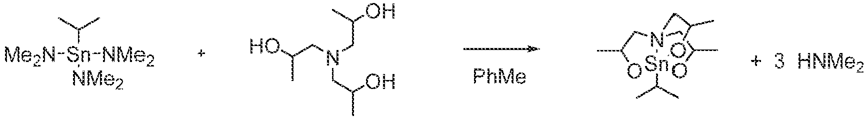

Under an inert atmosphere, 57.0 g (0.194 mol) of isopropyltris(dimethylamino)tin was charged to a 200 mL three-neck round bottom flask equipped with a magnetic stirrer, pot thermometer, thermowell, and addition funnel. A solution of 37.02 g (0.194 mol) triisopropanolamine in 43 mL toluene was added dropwise to the flask while maintaining the pot temperature below 40 °C. The reaction was stirred for 2 h and monitored by ¹¹⁹Sn-NMR. After completion, the product was isolated from the reaction mixture by distillation under reduced pressure (108-110°C at 0.3 torr (0.b4 kPa)) to yield 41.1 g (65%) of a white, crystalline solid with a melting point of 93-94 °C. The product was confirmed by ¹H and ¹¹⁹Sn NMR spectroscopy as a pair of diastereomers with a ratio of ca. 2.5:1, having the properties shown in Table 3. By ¹¹⁹Sn NMR less than 0.1% concentration of any dialkyl tin species was observed.

UV Exposure: The product in a saturated cyclohexane solution was exposed to 8 hours of illumination and no traces of decomposition were observed in either ¹¹⁹Sn or ¹H NMR spectra. No signs of decomposition of the product sample were observed. By ¹¹⁹Sn NMR less than 0.1% concentration of any dialkyl tin species was observed.

Heat Exposure: The product in a saturated cyclohexane solution was exposed to heat at 35 °C for one week and no traces of decomposition were observed in either ¹¹⁹Sn or ¹H NMR spectra. No signs of decomposition of the product sample were observed. By ¹¹⁹Sn NMR less than 0.1% concentration of any dialkyl tin species was observed.

**Table 3: Properties of 1-iso-propyl-3,7,10-trimethyl-2,8,9-trioxa-5-aza-1-stannabicyclo [3.3.3] undecane**

| **Structure** | **¹¹⁹Sn Peak (ppm, CDCl₃)** | **¹H Peaks (ppm, CDCl₃)** | **Physical Properties** |
|---|---|---|---|
| 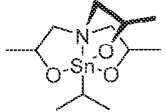 | -219 (major diastereomer) | 4.10 (m, 1H, major) | White, crystalline solid |
| | | 3.84 (m, 2H, major, and 3H, minor) | |
| | -222 (minor diastereomer) | | MP = 93 °C (DSC). |
| | | 3.03 (dd, 1H, major) | BP = 108-10 °C/0.3 mmHg |
| | | 2.97 (dd, 1H, major) | |
| | | 2.83 (dd, 1H, major) | |
| | | 2.75 (dd, 3H, minor) | |
| | | 2.63 (dd, 1H, major)) | |
| | | 2.32 (t, 3H, minor) | |
| | | 2.28 (t, 1H, major) | |
| | | 2.25 (t, 1H, major) | |
| | | 1.97 (m. 1H major) | |
| | | 1.60 (m, 1H, minor) | |
| | | 1.41 (m, 6H) | |
| | | 1.19 (m, 9H) | |

### Example 4: Synthesis of 1-iso-propyl-3,7,9-2,5,8,9-tetraaza-1-stannabicyclo[3.3.3] undecane

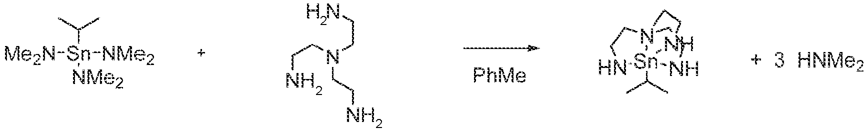

Under an inert atmosphere, 132.30 g (0.45 mol) of isopropyltris(dimethylamino)tin was charged to a 500 mL three-neck round bottom flask equipped with a magnetic stirrer, pot thermometer, thermowell, and addition funnel. A solution of 65.80 g(0.45 mol) tris(2-aminoethyl)amine in 75.90 mL toluene was added dropwise to the flask while maintaining the pot temperature below 40 °C. The reaction was stirred for 2 h and monitored by ¹¹⁹Sn-NMR. After completion (off-gas stopped), 90% of solvents in the reaction mixture were removed by vacuum distillation to give a solid product mixture, and dry hexane was added to precipitate the title compound: 107.4 g (83.78%) of a pale-yellow solid with a melting point of 58 °C. The product was confirmed by ¹H and ¹¹⁹Sn NMR spectroscopy and had the properties shown in Table 4. By ¹¹⁹Sn NMR less than 0.1% concentration of any dialkyl tin species was observed.

**Table 4: Properties of 1-iso-propyl-2,58,9-tetraaza-1-stannabicyclo[3.3.3] undecane**

| **Structure** | **¹¹⁹Sn Peak (ppm, C6D6)** | **¹H Peaks (ppm, C6D6)** | **Physical Properties** |
|---|---|---|---|
| 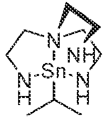 | -81.46 | 0.352 (b, 3H) | Pale yellow solid |
| | | 1.14 (m, 1H) | MP = 58 °C (DSC). |
| | | 1.22(d, 6H) | |
| | | 2.21 (m, 6H) | |
| | | 2.92 (m, 6H) | |

### Example 5: Surface Modification of Silicon Wafers with 1-n-Butyl-3,7,10-trimethyl-2,8,9-trioxa-5-aza-1-stannabicyclo[3.3.3] undecane

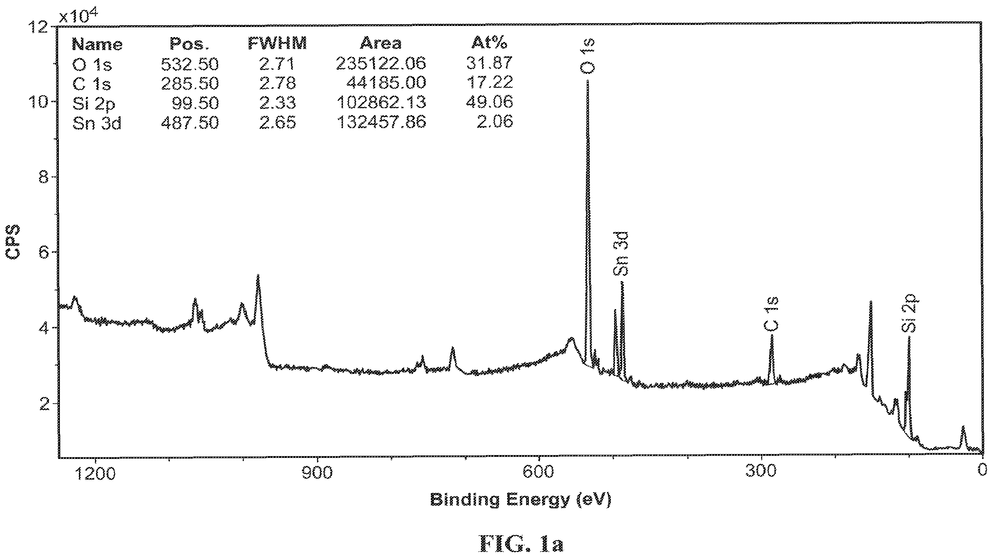

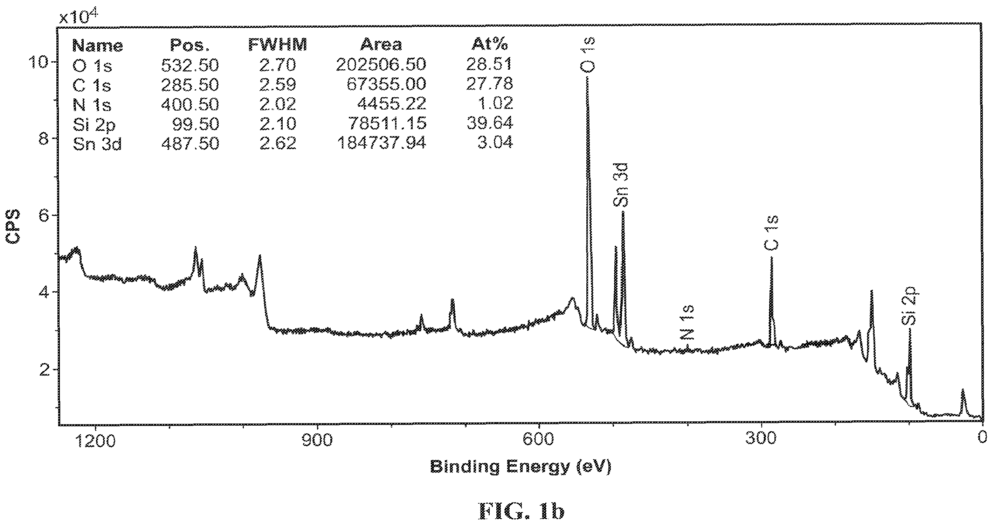

All operations were performed in ambient laboratory conditions. Silicon wafers were cleaned and dried in the dry box using a hotplate set to 120°C (or at ambient temperature). 0.20 g 1-n-butyl-2,8,9-trioxa-5-aza-1-stannabicyclo[3.3.3] undecane as prepared in Example 1 was placed in 15.1 g absolute EtOH and stirred at 30 min at 45 °C. Samples were prepared in duplicate. Sample A was immersed in the solution for 5 min and dried at 120 °C for 5 minutes and Sample B was immersed in the solution for 5 min and then dried at room temperature overnight. The XPS spectra for Samples A and B are shown in Fig. 1a and Fig. 1b.

Fig. 1a is an XPS spectrum of silicon wafers coated with 1-n-butyl-2,8,9-trioxa-5-aza-1-stannabicyclo[3.3.3] undecane after being immersed for five minutes and dried at 120 °C for five minutes, and Fig. 1b is an XPS spectrum of silicon wafers coated with 1-n-butyl-2,8,9-trioxa-5-aza-1-stannabicyclo[3.3.3] undecane after being immersed for five minutes and dried at room temperature overnight. The spectra prove that oxostannate films were successfully deposited on silicon wafers.

### Example 6: Surface Modification of Silicon Wafers with 1-isopropyl-3,7,10-trimethyl-2,8, 9-trioxa-5-aza-1-stannabicyclo[3.3.3] undecane

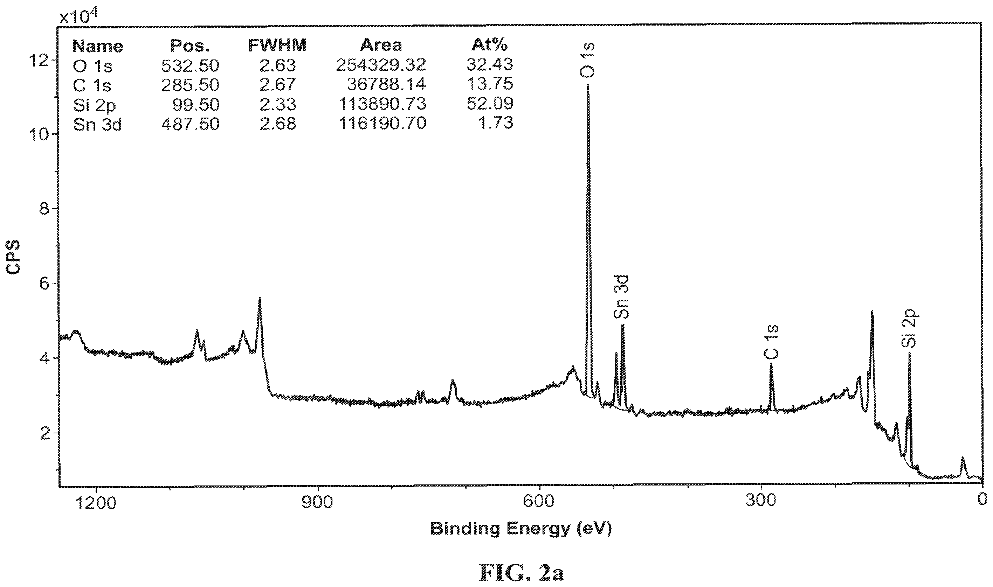

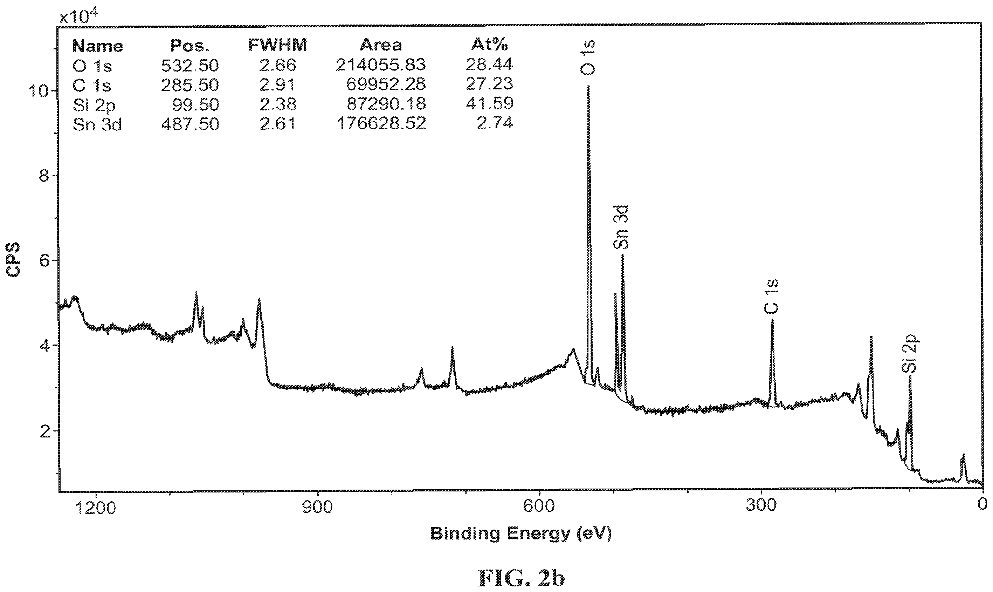

All operations were performed in ambient laboratory conditions. Silicon wafers were cleaned and dried in the dry box using a hotplate set to 120°C (or at ambient temperature). 0.20 g 1-iso-propyl-2,8,9-trioxa-5-aza-1-stannabicyclo[3.3.3] undecane as prepared in Example 3 was placed in 15.1 g absolute EtOH and stirred at 30 min at 45 °C. Samples were prepared in duplicate. Sample A was immersed in the solution for five minutes and dried at 120 °C for 5 minutes and Sample B was immersed in the solution for five minutes and then dried at room temperature overnight. The XPS spectra for Samples A and B are shown in Fig. 2a and Fig. 2b.

Fig. 2a is an XPS spectrum of silicon wafers coated with 1-iso-propyl-2,8,9-trioxa-5-aza-1-stannabicyclo[3.3.3] undecane after being immersed for five minutes and dried at 120 °C for five minutes, and Fig. 2b is an XPS spectrum of silicon wafers coated with 1-iso-propyl-2,8,9-trioxa-5-aza-1-stannabicyclo[3.3.3] undecane after being immersed for five minutes and dried at room temperature overnight. The spectra prove that oxostannate films were successfully deposited on silicon wafers.

### Example 7: Surface Modification of Silicon Wafers with 1-(3,3,3-Trifluoropropyl)- 3,7,10-trimethyl-2,8,9-trioxa-5-aza-1-stannabicyclo[3.3.3] undecane

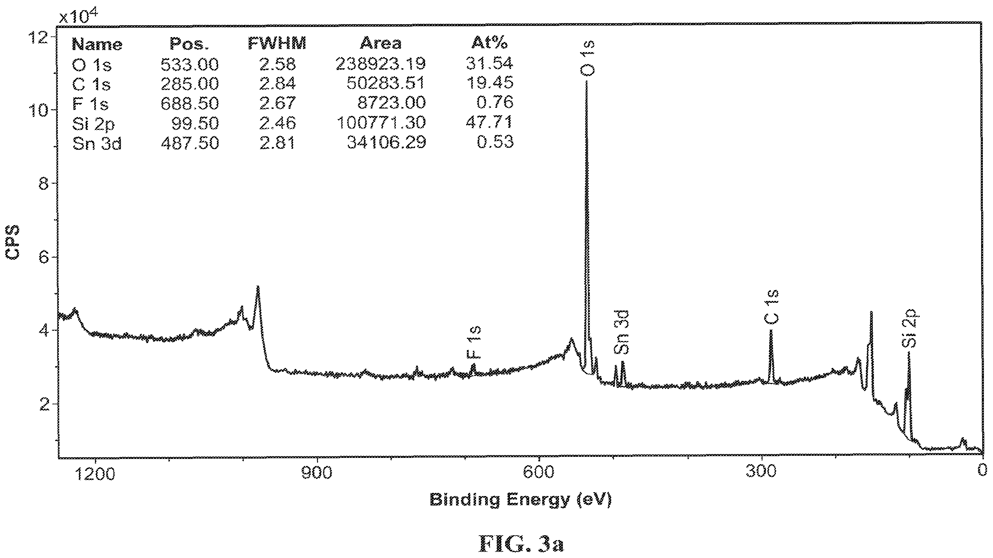

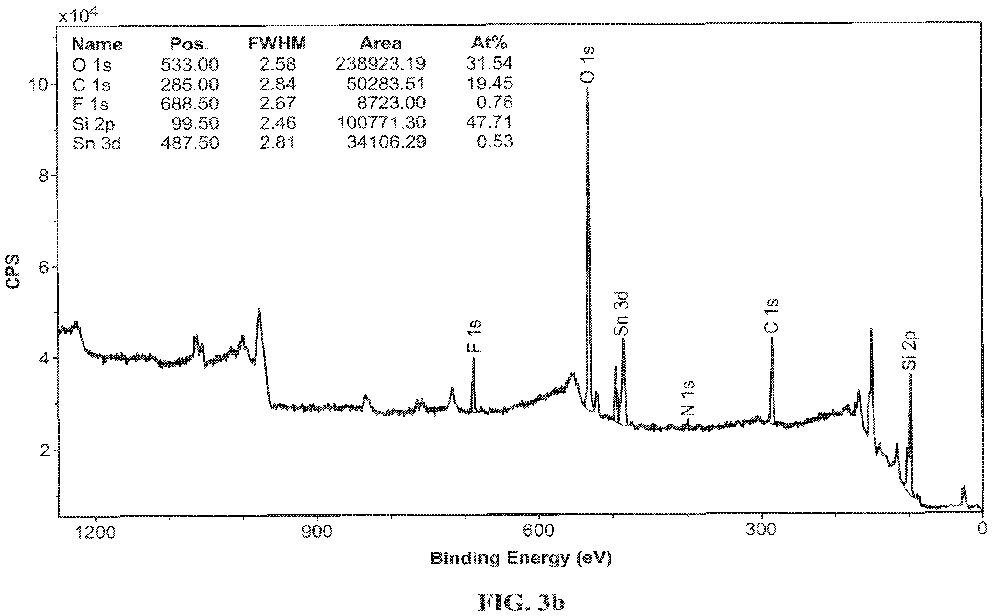

All operations were performed in ambient laboratory conditions. Silicon wafers were cleaned and dried in the dry box using a hotplate set to 120°C (or at ambient temperature). 0.20 g 1-(3,3,3-Trifluoropropyl-2,8,9-trioxa-5-aza-1-stannabicyclo[3.3.3] undecane as prepared in Example 2 was placed in 15.1 g absolute EtOH and stirred at 30 min at 45 °C. Samples were prepared in duplicate. Sample A was immersed in the solution for five minutes and dried at 120 °C for 5 minutes and Sample B was immersed in the solution for five minutes and then dried at room temperature overnight. The XPS spectra for Samples A and B are shown in Fig. 3a and Fig. 3b.

Fig. 3a is an XPS spectrum of silicon wafers coated with 1-(3,3,3-trifluoropropyl-2,8, 9-trioxa-5-aza-1-stannabicyclo[3.3.3] undecane after being immersed for five minutes and dried at 120 °C for five minutes, and Fig. 3b is an XPS spectrum of silicon wafers coated with 1-(3,3,3-trifluoropropyl-2,8,9-trioxa-5-aza-1-stannabicyclo[3.3.3] undecane after being immersed for five minutes and dried at room temperature overnight. The spectra prove that oxostannate films were successfully deposited on silicon wafers.

It will be appreciated by those skilled in the art that changes could be made to the embodiments described above within the scope of the claims. It is understood, therefore, that this invention is not limited to the particular embodiments disclosed, but it is intended to cover modifications within the scope of the present invention as defined by the appended claims.

## Claims

1. A stannatrane having formula (I): 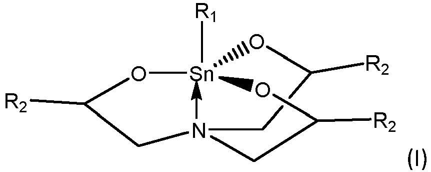
wherein R₁ is a substituted or unsubstituted, linear or branched, alkyl group having one to about ten carbon atoms, a substituted or unsubstituted cycloalkyl group having three to about twenty carbon atoms, or a substituted or unsubstituted alkenyl group having two to about ten carbon atoms, and each R₂ is independently hydrogen or a substituted or unsubstituted, linear or branched, alkyl group having one to about ten carbon atoms, provided that at least one R₂ is not hydrogen,
wherein, if R₁ and/or R₂ are substituted, they are substituted with one or more halogen atoms or a trimethylsilyl group.

2. The stannatrane according to claim 1, having the formula 1-n-butyl-3,7,10-trimethyl-2, 8,9-trioxa-5-aza-1-stannabicyclo[3.3.3] undecane:

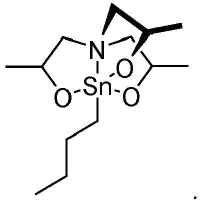

3. The stannatrane according to claim 1, having the formula 1-(3,3,3-trifluoropropyl)-3,7,10-trimethyl-2,8,9-trioxa-5-aza-1-stannabicyclo[3.3.3] undecane:

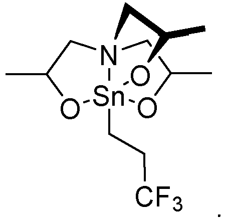

4. The stannatrane according to claim 1, having the formula 1-iso-propyl-3,7,10-trimethyl-2,8,9-trioxa-5-aza-1-stannabicyclo[3.3.3] undecane:

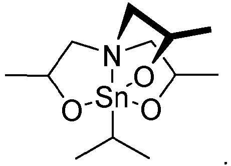

5. The stannatrane according to any of claims 1-4, having a purity of at least about 99.9%.

6. The stannatrane according to any of claims 1-5, wherein the stannatrane contains less than about 0.1 % dialkyl tin compounds.

7. A method for forming a stannatrane according to any of claims 1-6, the method comprising:
reacting an alkali metal alkoxide with a triisopropanolamine and an alkyltin trichloride compound having formula R₁SnCl₃.

8. A method for forming a stannatrane according to any of claims 1-6, the method comprising:
reacting an alkyltris(dimethylamino)tin compound having formula R₁Sn(NMe₂)₃ with triisopropanolamine.

9. An azastannatrane having formula (II): 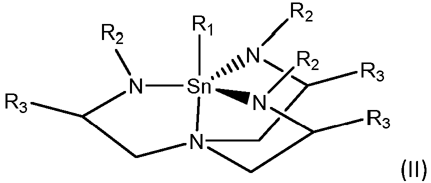
wherein R₁ is a substituted or unsubstituted, linear or branched, alkyl group having one to about ten carbon atoms, a substituted or unsubstituted cycloalkyl group having three to about twenty carbon atoms, or a substituted or unsubstituted alkenyl group having two to about ten carbon atoms, each R₂ is independently hydrogen or a substituted or unsubstituted, linear or branched, alkyl group having one to about ten carbon atoms, and each R₃ is independently hydrogen or a substituted or unsubstituted, linear or branched, alkyl group having one to about ten carbon atoms, provided that at least one R₃ is not hydrogen,
wherein, if R₁ and/or R₂ and/or R₃ are substituted, they are substituted with one or more halogen atoms or a trimethylsilyl group.

10. The azastannatrane according to claim 9, having a purity of at least about 99.9%.

11. The azastannatrane according to claim 9 or 10, wherein the azastannatrane contains less than about 0.1 % dialkyl tin compounds.

12. A method for forming an azastannatrane according to any of claims 9-11, the method comprising:
reacting an alkyltris(dimethylamino)tin compound having formula R₁Sn(NMe₂)₃ with tris(2-aminoethyl)amine.

13. A method for forming an oxostannate film comprising:
providing a substrate;
coating the substrate with a solution of a stannatrane according to any of claims 1-6;
drying and/or heating the coated substrate;
irradiating the coated substrate; and
exposing the irradiated substrate to oxygen or moisture to form the oxostannate film on the substrate.

14. A method for forming an oxostannate film comprising:
providing a substrate;
coating the substrate with a solution of an azastannatrane according to any of claims 9-11;
drying and/or heating the coated substrate;
irradiating the coated substrate; and
exposing the irradiated substrate to oxygen or moisture to form the oxostannate film on the substrate.

15. A method for forming an oxostannate film comprising:
vaporizing or providing an aerosol of the stannatrane according to any of claims 1-6;
providing a substrate;
physisorbing or chemisorbing the vaporized or aerosolized stannatrane onto the substrate; and
exposing the physisorbed or chemisorbed stannatrane to a sequence of hydrolysis and irradiation steps followed by an oxidation or second hydrolytic exposure to form the oxostannate film on the substrate.

16. A method for forming an oxostannate film comprising:
vaporizing or providing an aerosol of an azastannatrane according to any of claims 9-11;
providing a substrate;
physisorbing or chemisorbing the vaporized or aerosolized azastannatrane onto the substrate; and
exposing the physisorbed or chemisorbed azastannatrane to a sequence of hydrolysis and irradiation steps followed by an oxidation or second hydrolytic exposure to form the oxostannate film on the substrate.

17. A method for forming a patterned film comprising preparing the oxostannate film according to any one of claims 13 to 16 and exposing the film to non-continuous radiation by rastering with an electron beam or laser or lithographic masking.

18. A method for forming a continuous film comprising preparing the oxostannate film according to any one of claims 13 to 16 and exposing the film to blanket exposure utilizing a suitable lithographic mask to provide optically clear tin oxide conductive film.

## Patentansprüche

1. Ein Stannatran der Formel (I): 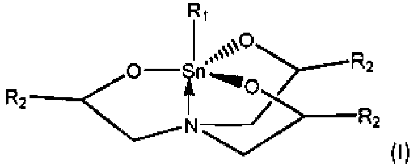
wobei R₁ eine substituierte oder unsubstituierte, lineare oder verzweigte Alkylgruppe mit einem bis etwa zehn Kohlenstoffatomen, eine substituierte oder unsubstituierte Cycloalkylgruppe mit drei bis etwa zwanzig Kohlenstoffatomen oder eine substituierte oder unsubstituierte Alkenylgruppe mit zwei bis etwa zehn Kohlenstoffatomen ist und jedes R₂ unabhängig Wasserstoff oder eine substituierte oder unsubstituierte, lineare oder verzweigte Alkylgruppe mit einem bis etwa zehn Kohlenstoffatomen ist, mit der Maßgabe, dass mindestens ein R₂ kein Wasserstoff ist,
wobei, wenn R₁ und/oder R₂ substituiert sind, sie mit einem oder mehreren Halogenatomen oder einer Trimethylsilylgruppe substituiert sind.

2. Das Stannatran nach Anspruch 1 mit der Formel 1-n-Butyl-3,7,10-trimethyl-2,8,9-trioxa-5-aza-1-stannabicyclo[3.3.3]undecan:

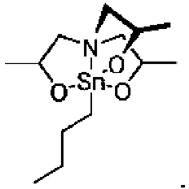

3. Das Stannatran nach Anspruch 1 mit der Formel 1-(3,3,3-Trifluorpropyl)-3,7,10-trimethyl-2,8,9-trioxa-5-aza-1-stannabicyclo[3.3.3]undecan:

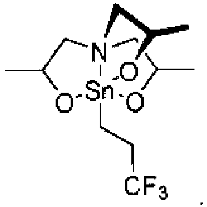

4. Das Stannatran nach Anspruch 1 mit der Formel 1-Isopropyl-3,7,10-trimethyl-2,8,9-trioxa-5-aza-1-stannabicyclo[3.3.3]undecan:

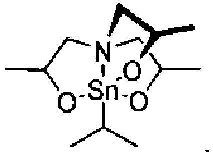

5. Das Stannatran nach einem der Ansprüche 1-4 mit einer Reinheit von mindestens etwa 99,9%.

6. Das Stannatran nach einem der Ansprüche 1-5, wobei das Stannatran weniger als etwa 0,1% Dialkylzinnverbindungen enthält.

7. Ein Verfahren zur Bildung eines Stannatrans nach einem der Ansprüche 1-6, wobei das Verfahren umfasst:
Umsetzen eines Alkalimetallalkoxids mit einem Triisopropanolamin und einer Alkylzinntrichloridverbindung der Formel R₁SnCl₃.

8. Ein Verfahren zur Bildung eines Stannatrans nach einem der Ansprüche 1-6, wobei das Verfahren umfasst:
Umsetzen einer Alkyltris(dimethylamino)zinnverbindung der Formel R₁Sn(NMe₂)₃ mit Triisopropanolamin.

9. Ein Azastannatran der Formel (II): 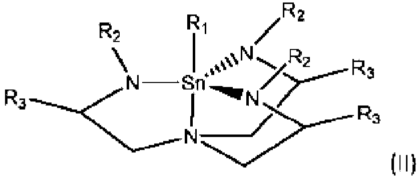
wobei R₁ eine substituierte oder unsubstituierte, lineare oder verzweigte Alkylgruppe mit einem bis etwa zehn Kohlenstoffatomen, eine substituierte oder unsubstituierte Cycloalkylgruppe mit drei bis etwa zwanzig Kohlenstoffatomen oder eine substituierte oder unsubstituierte Alkenylgruppe mit zwei bis etwa zehn Kohlenstoffatomen ist, jedes R₂ unabhängig Wasserstoff oder eine substituierte oder unsubstituierte, lineare oder verzweigte Alkylgruppe mit einem bis etwa zehn Kohlenstoffatomen ist und jedes R₃ unabhängig Wasserstoff oder eine substituierte oder unsubstituierte, lineare oder verzweigte Alkylgruppe mit einem bis etwa zehn Kohlenstoffatomen ist, mit der Maßgabe, dass mindestens ein R₃ kein Wasserstoff ist,
wobei, wenn R₁ und/oder R₂ und/oder R₃ substituiert sind, sie mit einem oder mehreren Halogenatomen oder einer Trimethylsilylgruppe substituiert sind.

10. Das Azastannatran nach Anspruch 9 mit einer Reinheit von mindestens etwa 99,9%.

11. Das Azastannatran nach Anspruch 9 oder 10, wobei das Azastannatran weniger als etwa 0,1% Dialkylzinnverbindungen enthält.

12. Ein Verfahren zur Bildung eines Azastannatrans nach einem der Ansprüche 9-11, wobei das Verfahren umfasst:
Umsetzen einer Alkyltris(dimethylamino)zinnverbindung der Formel R₁Sn(NMe₂)₃ mit Tris(2-aminoethyl)amin.

13. Ein Verfahren zur Bildung eines Oxostannat-Films, umfassend:
Bereitstellen eines Substrats;
Beschichten des Substrats mit einer Lösung eines Stannatrans nach einem der Ansprüche 1-6;
Trocknen und/oder Erwärmen des beschichteten Substrats;
Bestrahlen des beschichteten Substrats; und
Aussetzen des bestrahlten Substrats gegenüber Sauerstoff oder Feuchtigkeit, um den Oxostannat-Film auf dem Substrat zu bilden.

14. Ein Verfahren zur Bildung eines Oxostannat-Films, umfassend:
Bereitstellen eines Substrats;
Beschichten des Substrats mit einer Lösung eines Azastannatrans nach einem der Ansprüche 9-11;
Trocknen und/oder Erwärmen des beschichteten Substrats;
Bestrahlen des beschichteten Substrats; und
Aussetzen des bestrahlten Substrats gegenüber Sauerstoff oder Feuchtigkeit, um den Oxostannat-Film auf dem Substrat zu bilden.

15. Ein Verfahren zur Bildung eines Oxostannat-Films, umfassend:
Verdampfen oder Bereitstellen eines Aerosols des Stannatrans nach einem der Ansprüche 1-6;
Bereitstellen eines Substrats;
Physisorption oder Chemisorption des verdampften oder vernebelten Stannatrans auf das Substrat; und
Aussetzen des physisorbierten oder chemisorbierten Stannatrans einer Abfolge von Hydrolyse- und Bestrahlungsschritten, gefolgt von einer Oxidation oder einem zweiten Aussetzen gegenüber Hydrolyse, um den Oxostannat-Film auf dem Substrat zu bilden.

16. Ein Verfahren zur Bildung eines Oxostannat-Films, umfassend:
Verdampfen oder Bereitstellen eines Aerosols eines Azastannatrans nach einem der Ansprüche 9-11;
Bereitstellen eines Substrats;
Physisorption oder Chemisorption des verdampften oder vernebelten Azastannatrans auf das Substrat; und
Aussetzen des physisorbierten oder chemisorbierten Azastannatrans einer Abfolge von Hydrolyse- und Bestrahlungsschritten, gefolgt von einer Oxidation oder einem zweiten Aussetzen gegenüber Hydrolyse, um den Oxostannat-Film auf dem Substrat zu bilden.

17. Ein Verfahren zur Bildung eines gemusterten Films, umfassend Herstellen des Oxostannat-Films nach einem der Ansprüche 13 bis 16 und Belichten des Films mit diskontinuierlicher Strahlung durch Rasterung mit einem Elektronenstrahl oder Laser oder durch lithographische Maskierung.

18. Ein Verfahren zur Bildung eines kontinuierlichen Films, umfassend Herstellen des Oxostannat-Films nach einem der Ansprüche 13 bis 16 und Aussetzen des Films gegenüber flächendeckender Belichtung unter Verwendung einer geeigneten lithographischen Maske, um einen optisch klaren leitfähigen Zinnoxid-Film bereitzustellen.

## Revendications

1. Stannatrane de formule (I) : 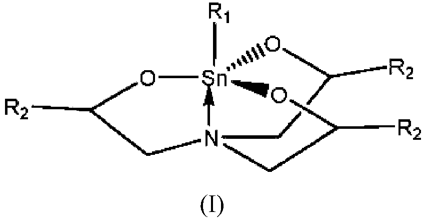
dans laquelle R₁ est un groupe alkyle linéaire ou ramifié, substitué ou non substitué, ayant de un à environ dix atomes de carbone, un groupe cycloalkyle substitué ou non substitué ayant de trois à environ vingt atomes de carbone, ou un groupe alcényle substitué ou non substitué ayant de deux à environ dix atomes de carbone, et chaque R₂ est indépendamment un hydrogène ou un groupe alkyle linéaire ou ramifié, substitué ou non substitué, ayant de un à environ dix atomes de carbone, sous réserve qu'au moins un R₂ ne soit pas un hydrogène,
dans laquelle, si R₁ et/ou R₂ sont substitués, ils sont substitués par un ou plusieurs atomes d'halogène ou un groupe triméthylsilyle.

2. Stannatrane selon la revendication 1, de formule 1-n-butyl-3,7,10-triméthyl-2,8,9-trioxa-5-aza-1-stannabicyclo[3.3.3]undécane :

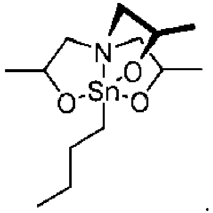

3. Stannatrane selon la revendication 1, de formule 1-(3,3,3-trifluoropropyl)-3,7,10-triméthyl-2,8,9-trioxa-5-aza-1-stannabicyclo[3.3.3]undécane :

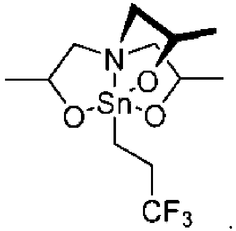

4. Stannatrane selon la revendication 1, de formule 1-isopropyl-3,7,10-triméthyl-2,8,9-trioxa-5-aza-1-stannabicyclo[3.3.3]undécane :

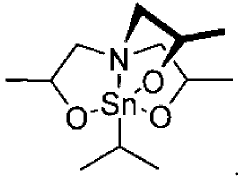

5. Stannatrane selon l'une quelconque des revendications 1 à 4, ayant une pureté d'au moins environ 99,9 %.

6. Stannatrane selon l'une quelconque des revendications 1 à 5, dans lequel le stannatrane contient moins d'environ 0,1 % de composés dialkyl-étain.

7. Méthode pour former un stannatrane selon l'une quelconque des revendications 1 à 6, la méthode comprenant :
la réaction d'un alkoxyde de métal alcalin avec une triisopropanolamine et un composé trichlorure d'alkyl-étain de formule R₁SnCl₃.

8. Méthode pour former un stannatrane selon l'une quelconque des revendications 1 à 6, la méthode comprenant :
la réaction d'un composé alkyltris(diméthylamino)étain de formule R₁Sn(NMe₂)₃ avec de la triisopropanolamine.

9. Azastannatrane de formule (II) : 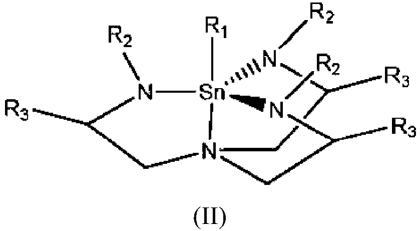
dans laquelle R₁ est un groupe alkyle linéaire ou ramifié, substitué ou non substitué, ayant de un à environ dix atomes de carbone, un groupe cycloalkyle substitué ou non substitué ayant de trois à environ vingt atomes de carbone, ou un groupe alcényle substitué ou non substitué ayant de deux à environ dix atomes de carbone, chaque R₂ est indépendamment un hydrogène ou un groupe alkyle linéaire ou ramifié, substitué ou non substitué, ayant de un à environ dix atomes de carbone, et chaque R₃ est indépendamment un hydrogène ou un groupe alkyle linéaire ou ramifié, substitué ou non substitué, ayant de un à environ dix atomes de carbone, sous réserve qu'au moins un R₃ ne soit pas un hydrogène,
dans laquelle, si R₁ et/ou R₂ et/ou R₃ sont substitués, ils sont substitués par un ou plusieurs atomes d'halogène ou un groupe triméthylsilyle.

10. Azastannatrane selon la revendication 9, ayant une pureté d'au moins environ 99,9 %.

11. Azastannatrane selon la revendication 9 ou 10, dans lequel l'azastannatrane contient moins d'environ 0,1 % de composés dialkyl-étain.

12. Méthode pour former un azastannatrane selon l'une quelconque des revendications 9 à 11, la méthode comprenant :
la réaction d'un composé alkyltris(diméthylamino)étain de formule R₁Sn(NMe₂)₃ avec de la tris(2-aminoéthyl)amine.

13. Méthode pour former un film d'oxostannate, comprenant :
la fourniture d'un substrat ;
le revêtement du substrat avec une solution d'un stannatrane selon l'une quelconque des revendications 1 à 6 ;
le séchage et/ou le chauffage du substrat revêtu ;
l'irradiation du substrat revêtu ; et
l'exposition du substrat irradié à l'oxygène ou à l'humidité pour former le film d'oxostannate sur le substrat.

14. Méthode pour former un film d'oxostannate, comprenant :
la fourniture d'un substrat ;
le revêtement du substrat avec une solution d'un azastannatrane selon l'une quelconque des revendications 9 à 11 ;
le séchage et/ou le chauffage du substrat revêtu ;
l'irradiation du substrat revêtu ; et
l'exposition du substrat irradié à l'oxygène ou à l'humidité pour former le film d'oxostannate sur le substrat.

15. Méthode pour former un film d'oxostannate, comprenant :
la vaporisation ou la fourniture d'un aérosol du stannatrane selon l'une quelconque des revendications 1 à 6 ;
la fourniture d'un substrat ;
la physisorption ou la chimisorption du stannatrane vaporisé ou sous forme d'aérosol sur le substrat ; et
l'exposition du stannatrane physisorbé ou chimisorbé à une séquence d'étapes d'hydrolyse et d'irradiation, suivie d'une oxydation ou d'une deuxième exposition hydrolytique pour former le film d'oxostannate sur le substrat.

16. Méthode pour former un film d'oxostannate, comprenant :
la vaporisation ou la fourniture d'un aérosol d'un azastannatrane selon l'une quelconque des revendications 9 à 11 ;
la fourniture d'un substrat ;
la physisorption ou la chimisorption de l'azastannatrane vaporisé ou sous forme d'aérosol sur le substrat ; et
l'exposition de l'azastannatrane physisorbé ou chimisorbé à une séquence d'étapes d'hydrolyse et d'irradiation, suivie d'une oxydation ou d'une deuxième exposition hydrolytique pour former le film d'oxostannate sur le substrat.

17. Méthode pour former un film à motifs, comprenant la préparation du film d'oxostannate selon l'une quelconque des revendications 13 à 16 et l'exposition du film à une rayonnement discontinu par balayage avec un faisceau d'électrons ou un laser ou par masquage lithographique.

18. Méthode pour former un film continu, comprenant la préparation du film d'oxostannate selon l'une quelconque des revendications 13 à 16 et l'exposition du film à une exposition globale en utilisant un masque lithographique approprié afin de fournir un film conducteur d'oxyde d'étain optiquement transparent.
